# EUROPEAN PATENT SPECIFICATION

(11) **EP 3 303 517 B1**
(45) Date of publication and mention of the grant of the patent: **03.04.2019**
(21) Application number: 16727497.6
(22) Date of filing: 07.06.2016
(51) Int. Cl.: C09K 11/79, H01L 33/50

(54) **COMPOSITE OXYNITRIDE CERAMIC CONVERTER AND LIGHT SOURCE HAVING SAME**
OXYNITRIDKERAMIKVERBUNDWANDLER UND LICHTQUELLE DAMIT
CONVERTISSEUR COMPOSITE EN CÉRAMIQUE D'OXYNITRURE ET SOURCE DE LUMIÈRE L'UTILISANT

(30) Priority: 08.06.2015 US 201562172552 P
(43) Date of publication of application: 11.04.2018
(73) Proprietor: OSRAM Opto Semiconductors GmbH, 93055 Regensburg (DE)
(72) Inventor: YU, Zhengbo, Shrewsbury, Massachusetts 01545 (US); MONTANER, Jason, Natick, Massachusetts 01760 (US); RAUKAS, Madis, Lexington, Massachusetts 02421 (US); ZHENG, Yi, Lynnfield, Massachusetts 01940 (US); TRAGL, Sonja, 86199 Augsburg (DE); EISERT, Dominik, 93049 Regensburg (DE)
(74) Representative: Epping - Hermann - Fischer
(86) International application number: PCT/EP2016/062891
(87) International publication number: WO 2016/198395

(56) References cited:
- WO-A1-2004/030109
- WO-A1-2009/031089
- WO-A1-2010/024981
- US-A1- 2014 021 855
- HAJIME YAMAMOTO ET AL: "Effects of Fluxes on Particle Morphology and Phase Formation of (Sr,Ba)Si", ECS TRANSACTIONS, 1 January 2011 (2011-01-01), pages 109-114, XP055291668, US ISSN: 1938-5862, DOI: 10.1149/1.3578026
- KIM HYUN-GU ET AL: "Preparation and luminescence properties ofBa3Si6O9N4:Eu2+phosphor", OPTICAL MATERIALS, ELSEVIER SCIENCE PUBLISHERS B.V. AMSTERDAM, NL, vol. 35, no. 6, 7 March 2013 (2013-03-07), pages 1279-1282, XP028525025, ISSN: 0925-3467, DOI: 10.1016/J.OPTMAT.2013.01.042

## Description

### Field of the Invention

This invention is related to Composite Oxynitride Ceramic Converter and Light Source Having Same.

### Background of the Invention

It is well known to use phosphors to convert blue light emitted from light emitting diodes (LEDs) into longer wavelengths ("wavelength conversion") in order to affect the overall color of the light emitted from the LED package. Such LEDs are generally referred to as phosphor-conversion LEDs (pc-LEDs). Depending on the application and desired light output, the phosphor may convert only a portion of the light emitted by the LED, as in the case of white LEDs, or the phosphor may effect a full conversion of the blue LED light to another color such as green.

The phosphor may be embedded in a silicone resin applied over the LED or in some advantageous applications it may be applied to the LED as a solid, sintered ceramic converter. Such solid, monolithic converters have at least two distinct advantages over phosphor powders. First, luminescent ceramic converters can be made in defined shapes and uniform thicknesses to provide better color consistency and control in manufacturing. Second, they can be made translucent which can reduce scattering losses and improve extraction efficiency. Examples of luminescent ceramic converters are described in U.S. Patent No. 7,554,258, U.S. Patent Application Publication 2007/0126017 and International Patent Application Publication No. WO 2006/087660. WO 2009/031089 A1 describes a light emitting device, especially an LED with a ceramic composite material essentially of the composition M1-yA2-xBxO2-2XN2+X:Euy, where M is selected from the group comprising Sr, Ca, Ba, Mg or mixtures thereof, A is selected from the group comprising Si, Ge or mixtures thereof, B is selected from the group comprising Al, B, Ga or mixtures thereof, and x and y are independently selected from > 0 to =1. Kim, Hyun-Gu et al. (Optical Material, Vol. 35, No. 6, 2013) describe the preparation and luminescence properties of a Ba3Si609N4:Eu2+ phosphor. Yamamoto, Hajime et al. (ECS Transactions, Vol. 33, 2011, pp. 109-114) describe the effects of fluxes on particle morphology and phase formation of (Sr,Ba)Si.

Oxynitride-based green-emitting phosphors such as β-SiAlON:Eu and SrSi₂O₂N₂:Eu provide many advantages in color gamut, thermal and chemical stability, and quenching effects. However, it is difficult to achieve dense ceramic parts with these materials even at high temperatures or long dwell times because they typically have a very low bulk diffusion coefficient, either elongated grains (β-SiAlON) or plate-like grains (SrSi₂O₂N₂), and large particle sizes. Hence, oxynitride ceramic converters normally have lower conversion efficiencies compared to their powdered form because of the severe scattering caused by the porous microstructure.

### Summary of the Invention

The present invention is a composite oxynitride ceramic converter that combines a first phase of a triclinic SrSi₂O₂N₂:Eu phosphor with a second phase of a hexagonal Sr₃Si₆N₄O₉:Eu phosphor to achieve a dense composite ceramic converter with a high quantum efficiency (QE) which may be used for green LED applications. In particular, the composite oxynitride ceramic converter preferably emits a green light with a peak wavelength from 540 to 570nm, and more preferably from 550 to 560nm.

In another aspect, the composite oxynitride ceramic converter has a relative molar proportion of x moles of the SrSi₂O₂N₂:Eu phosphor to (1-x) moles of the Sr₃Si₆N₄O₉:Eu phosphor where x is from 0.01 to 0.99, more preferably, from 0.20 to 0.80, and even more preferably from 0.30 to 0.60.

In a further aspect, the composite oxynitride ceramic converter is paired with an LED to form a light source. More particularly, the ceramic converter is preferably combined with a blue-emitting LED to substantially convert the blue light emitted by the LED to a green light thereby providing a green-emitting LED light source.

According to one embodiment the composite oxynitride ceramic converter having a first phase of a triclinic SrSi₂O₂N₂:Eu phosphor and a second phase of a hexagonal Sr₃Si₆N₄O₉:Eu phosphor.

According to one embodiment the SrSi₂O₂N₂:Eu phosphor and the Sr₃Si₆N₄O₉:Eu phosphor contain from 0.1 mole percent Eu to 5 mole percent Eu.

According to one embodiment the SrSi₂O₂N₂:Eu phosphor and the Sr₃Si₆N₄O₉:Eu phosphor contain from 0.1 mole percent Eu to 3 mole percent Eu.

According to one embodiment the SrSi₂O₂N₂:Eu phosphor and the Sr₃Si₆N₄O₉:Eu phosphor contain from 0.3 mole percent Eu to 1.5 mole percent Eu.

According to one embodiment the converter has a relative molar proportion of x moles of the SrSi₂O₂N₂:Eu phosphor to (1-x) moles of the Sr₃Si₆N₄O₉:Eu phosphor where x is from 0.01 to 0.99.

According to one embodiment the converter has a relative molar proportion of x moles of the SrSi₂O₂N₂:Eu phosphor to (1-x) moles of the Sr₃Si₆N₄O₉:Eu phosphor where x is from 0.20 to 0.80.

According to one embodiment the converter has a relative molar proportion of x moles of the SrSi₂O₂N₂:Eu phosphor to (1-x) moles of the Sr₃Si₆N₄O₉:Eu phosphor where x is from 0.30 to 0.60.

According to one embodiment the average grain size in the composite oxynitride ceramic converter is 0.1 to 10 µm.

According to one embodiment the average grain size the average grain size in the composite oxynitride ceramic converter is 2 to 10 µm.

According to one embodiment the converter emits a green light having a peak wavelength from 540 to 570nm.

According to one embodiment the converter emits a green light having a peak wavelength from 550 to 560nm.

According to one embodiment the converter comprises first grains having a plate-like shape and second grains having an elongated shape with a hexagonal cross section.

According to one embodiment the second grains having the elongated shape have an aspect ratio in a range of greater than 1 to less than about 12.

The light source comprising a light emitting diode (LED) and a composite oxynitride ceramic converter, the composite oxynitride ceramic converter having a first phase of a triclinic SrSi₂O₂N₂:Eu phosphor and a second phase of a hexagonal Sr₃Si₆N₄O₉:Eu phosphor.

According to one embodiment of the light source the SrSi₂O₂N₂:Eu phosphor and the Sr₃Si₆N₄O₉:Eu phosphor contain from 0.1 mole percent Eu to 5 mole percent Eu.

According to one embodiment of the light source the converter has a relative molar proportion of x moles of the SrSi₂O₂N₂:Eu phosphor to (1-x) moles of the Sr₃Si₆N₄O₉:Eu phosphor where x is from 0.20 to 0.80.

According to one embodiment of the light source the composite oxynitride ceramic converter emits a green light having a peak wavelength from 540 to 570nm.

According to one embodiment of the light source the LED emits a primary light and the composite oxynitride ceramic converter converts substantially all of the primary light to the green light.

According to one embodiment of the light source the primary light has a peak wavelength in the range of 420 to 490nm.

According to one embodiment of the light source the green light has a peak wavelength from 550 to 560nm.

### Brief Description of the Drawings

Figure 1 is a photomicrograph of the microstructure of a composite oxynitride ceramic converter according to this invention.
Figures 2A and 2B show the x-ray diffraction pattern for a composite oxynitride ceramic converter according to this invention overlaid with diffraction patterns for SrSi₂O₂N₂ and Sr₃Si₆N₄O₉ phases, respectively.
Figures 3A and 3B are illustrations of the crystal structures for the SrSi₂O₂N₂ and Sr₃Si₆N₄O₉ phases, respectively.
Figure 4A is a graphical comparison of the emission spectra of composite oxynitride ceramic converters formed by pressureless sintering and spark plasma sintering (SPS) techniques. Figure 4B shows the color points of composite oxynitride ceramic converters of Figure 4A.
Figure 5 is a cross-sectional illustration of a light source according to this invention.
Figures 6A to 6E show x-ray diffraction data.

### Detailed Description of the Invention

For a better understanding of the present invention, together with other and further objects, advantages and capabilities thereof, reference is made to the following disclosure and appended claims taken in conjunction with the above-described drawings.

References to the color of a phosphor, LED, laser or conversion material refer generally to its emission color unless otherwise specified. Thus, a blue LED emits a blue light, a yellow phosphor emits a yellow light and so on.

As used herein the term "ceramic converter" refers to a solid monolithic piece comprised of at least one sintered, polycrystalline luminescent material, such as an inorganic phosphor, that converts at least a portion of the light from an excitation source to light of a different wavelength. The ceramic converter has a density that is preferably at least about 90% of the theoretical density of the luminescent material that comprises it. A preferred density of the inventive composite oxynitride ceramic converter is at least about 95% of theoretical density. More preferably, the composite ceramic converter has a density that is at least about 98%, or even 99%, of theoretical density.

As described above, it is difficult to achieve a properly dense ceramic converter with green oxynitride phosphors such as β-SiAlON:Eu and SrSi₂O₂N₂:Eu. Methods including hot isostatic pressing (HIP), spark plasma sintering (SPS) or high pressure (HP) may be employed to produce ceramic converters, but with these phosphors the resulting parts are generally unsatisfactory because of the large amount of pores present in the ceramic bulk. For example, without addition of sintering aids, single-phase, elongated β-SiAlON:Eu does not densify even at 1725°C by SPS; and single-phase, plate-like SrSi₂O₂N₂:Eu parts generally have a lower QE, especially round about 30 % lower QE, either by SPS or pressureless sintering methods.

The present invention overcomes this problem by combining two oxynitride phases to form a composite oxynitride ceramic converter having a dense, homogeneous microstructure and a high QE which may be used in green pc-LED applications. In particular, the ceramic converter contains a first phase of a triclinic SrSi₂O₂N₂:Eu phosphor and a second phase of a hexagonal Sr₃Si₆N₄O₉:Eu phosphor. It is believed that the use of two phases instead of a single phase provides a greater driving force for densification. Although these two oxynitride phases are of similar chemical composition, they have a different of ratio of oxygen to nitrogen atoms (viz. the triclinic SrSi₂O₂N₂ phosphor has an O/N ratio of 1:1 whereas the hexagonal Sr₃Si₆N₄O₉ phosphor has a higher O/N ratio of 2.25:1.) The difference in the composition creates an unbalanced chemical potential which provides an additional driving force for better densification through mass diffusion/transportation during sintering and makes less costly pressureless sintering methods viable. On the optical performance side, the composite oxynitride ceramic converter offers a higher uncorrected conversion efficiency, ∼41%, than single phase SrSi₂O₂N₂:Eu converters (∼33-35%) made by pressureless sintering and provides a greener emission (555.3nm dominant wavelength and 546.5 nm dominant wavelength, respectively) compared to single phase SrSiO₂N₂:Eu (555.8nm dominant wavelength and 555 nm dominant wavelength, respectively).

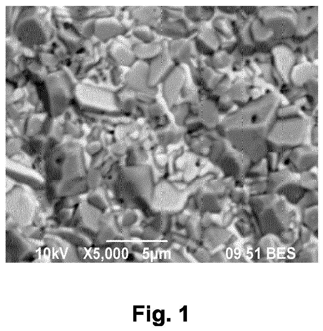

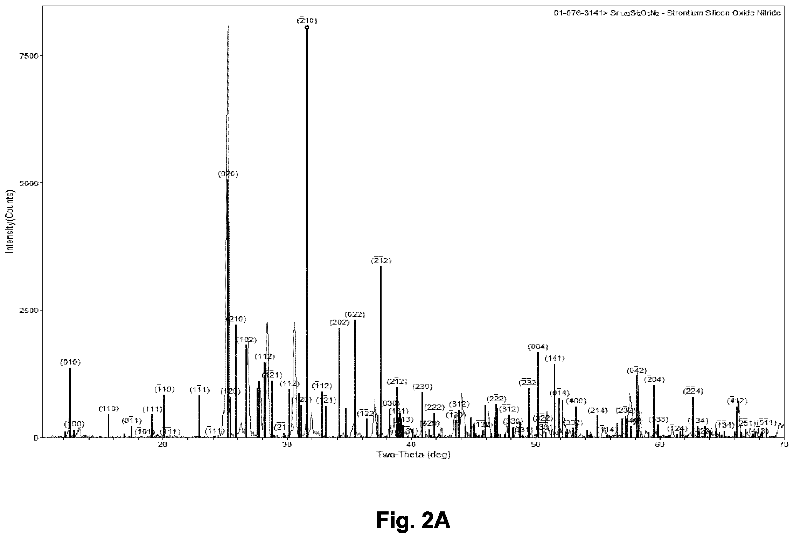

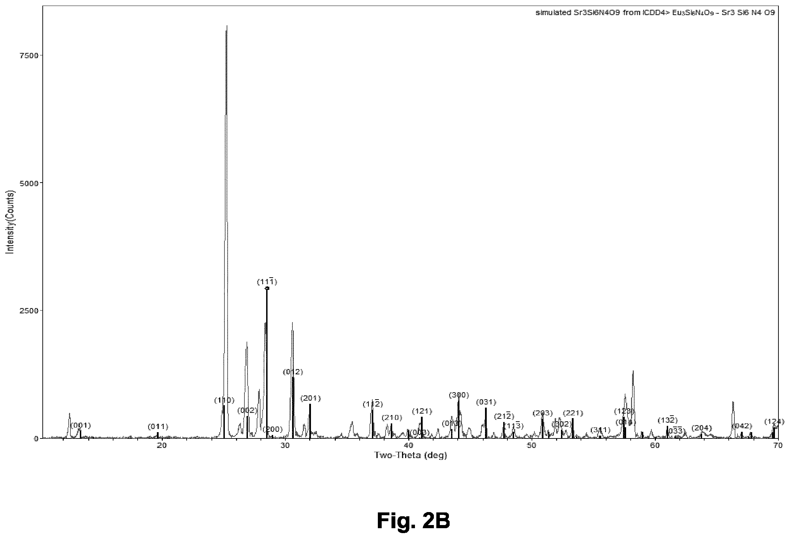

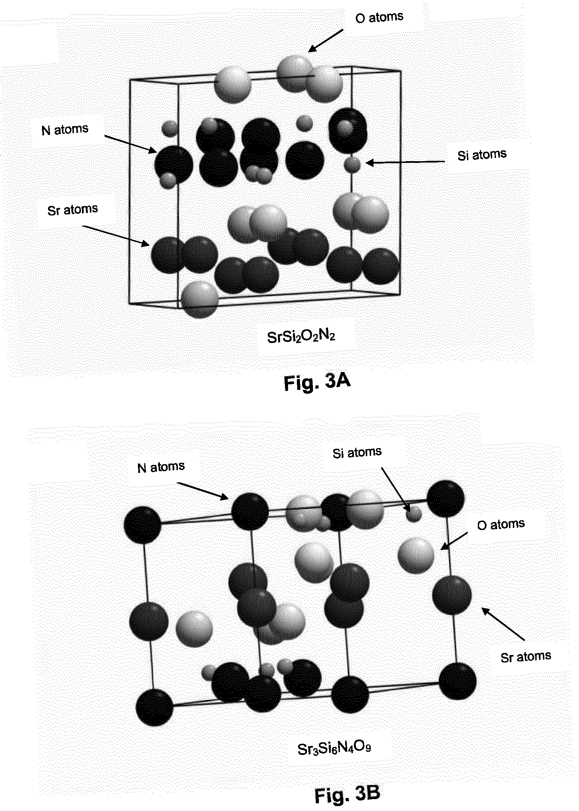

A typical microstructure of the SrSi₂O₂N₂:Eu/ Sr₃Si₆N₄O₉:Eu composite ceramic converter is shown in Figure 1 and consists of triclinic (light white plate-like shape) and hexagonal (dark) phases. The elongated hexagonal-shaped grains preferably have an aspect ratio (length to width) in a range of greater than 1 to less than about 12. The average grain size in the composite oxynitride ceramic converter is preferably 0.1 to 10 µm, more preferably 0.5 to 12 µm and even more preferably 2 to 10 µm. Figures 2A and 2B show an exemplary x-ray diffraction pattern for the composite oxynitride ceramic converter overlaid with diffraction patterns for the SrSi₂O₂N₂ and Sr₃Si₆N₄O₉ phases, respectively. The unit cell parameters were determined by x-ray diffraction (XRD) techniques based on the diffraction pattern for the hexagonal Sr₃Si₆N₄O₉ phase. The hexagonal crystal phase belongs to space group P3 (143) with cell dimensions a=7.106, c=6.6182, vol.=289.5. Crystal structural models of the two phases present in the composite are shown in Figures 3A (triclinic SrSi₂O₂N₂) and 3B (hexagonal Sr₃Si₆N₄O₉).

This invention is made based on green full conversion topic on SrSi₂O₂N₂ materials after a series of processing steps and conditions explored for optimization as below: (1) DoE of green SrSi₂O₂N₂ doped with Eu under different processing conditions. (2) Different debinding processing conditions (in air, vacuum at different temperatures). (3) Different sintering methods used e.g SPS and pressureless sintering. Steps (1) was designed to optimize the best starting powders, and step (2) to optimize the best debinding conditions, both steps was designed in such a way to modify the surface chemistry of the phosphor powders and even hence final compositions. Step (3) was designed to select and optimize the densification and luminescent performance by using different sintering methods and conditions. Firstly SPS was used for the evaluation of sintering behavior, conditions and optical performance of the DoE powders. It was found that the phosphor powders processed under the condition - milled in ethanol with no acid treatment resulted in the highest conversion efficiency (≈32.9% in sphere pinhole) among the DoE powders, even though minor unidentified 2nd phase present in the as received powder. Tape casting followed by debinding and pressureless sintering process was employed using the most promising DoE powder to explore the cost effective way to make ceramic converters. Ceramic converters made from powder were debinded and got partially oxidized, after pressureless sintering in N2, it was found a phase transformation from X SrSi₂O₂N₂ to Y Sr₃Si₆N₄O₉ occurred partially, i.e. the final ceramic converters consist of two major phases, SrSi₂O₂N₂ and Sr₃Si₆N₄O₉ the former is triclinic phase and the latter hexagonal structure. The composite ceramic converter gave a higher conversion efficiency (40.6% in pinhole) than that produced by SPS process (32.9%).

The composite oxynitride ceramic converters of this invention may be produced using starting powders in different forms. For example, the starting powders may comprise (1) oxynitride-based phosphor powders of solid solution composition SrₐSi_{b}O_{c}N_{d}:Eu, where 0.95≤a≤1.05, 1.5≤b≤2.5, 1.5≤c≤2.5, 1.5≤d≤2.5 and preferably containing 0.1 to 5 mole percent europium (mol%Eu); (2) mixed phosphor powders in a relative molar proportion of x moles SrSi₂O₂N₂:Eu to (1-x) moles Sr₃Si₆N₄O₉:Eu where x is between 0.01 to 0.99 and the phosphors are preferably doped with 0.1 to 5 mol%Eu; or (3) raw powders in the form of Sr, Si, Al, and Eu oxides or nitrides (for example SrO, SrCO₃, Sr₃N2, SiO₂, Si₃N₄, Al₂O₃, AlN, Eu₂O₃, SrSi₂O₂N₂, Sr₃Si₆O₁₂N₂, Sr₃Si₂O₄N₂, Sr₃Si₃O₉N₄, Sr₂Si₅OₓN₈₋ₓ etc.) having relative proportions designed such that the final composite ceramic converter consists of the two major phosphor phases SrSi₂O₂N₂:Eu and Sr₃Si₆N₄O₉:Eu. The composite converters may be produced by either solid state reaction, SPS, pressureless sintering, or other methods such as hot pressing, hot isostatic pressing and over pressure sintering. Preferably, the oxynitride phosphor phases contain 0.1 to 5 mol%Eu, more preferably 0.1 to 3mol%Eu, and even more preferably 0.3 to 1.5 mol%Eu.

### Example 1

Several different oxynitride phosphor powders (e.g. SrSi₂O₂N₂) with a Eu content of 0.1 to 10 or 0.1 to 5 mol%Eu were processed under different conditions. The powders had a particle size (d50) of between 0.20-5.0µm, with a preferred range of 0.50-3.0 µm. The main SrSi₂O₂N₂:Eu phosphor phase was determined to be ≥70 weight percent (wt.%) by XRD with a preferred range of 80wt.% - 99.9wt.%. Ceramic converters were formed by spark plasma sintering. The composite oxynitride phosphor powders were loaded in a graphite pressure die, and the die was heated by allowing a pulsed direct current to pass through it. Boron nitride paint was applied to the portions of the die assembly that came into contact with the powder to prevent a reaction between the powder and graphite. Samples with diameters of 15 and 20 mm, and thicknesses of ∼1.5-6.5 mm were sintered using a uniaxial pressure between 5-100 MPa with preferred range of 20-80 MPa. The pressure was applied at a temperature of between 500-1350°C, with a preferred range of 800-1300°C, and held constant until the end of the sintering cycle. Initially the samples were heated at a rate of 30-35°C/min in vacuum from room temperature until 950°C. A gas comprising Ar, N₂, H₂ or a combination thereof (preferably 100% N₂ or 2%H₂/98%N₂ (forming gas)) was introduced at 950°C and the sintering continued to the peak temperature. Typically, the ceramic converters were sintered at peak temperatures ranging from 1400-1600°C (preferably 1400-1500°C) for 1 to 360 minutes (preferably 5-240min. or 5-120 min.) Once the sintering process was complete, the samples were rapidly cooled to room temperature. The cooling rate from the final sintering temperature down to 500°C was approximately 350°C/min. The sintered ceramic cylinders were ground down to thin disks with a thickness range of about 50 to 200µm. Uncorrected conversion efficiencies ("pinhole efficiencies") were measured and the color points calculated. The uncorrected conversion efficiency is a parameter indicating how effectively the blue excitation light is converted into green on a photon-per-photon basis.

### Example 2

Oxynitride phosphor powders with compositions similar to Example 1 were suspended in aqueous or organic solvents, such as H₂O, ethanol, toluene, benzene, hexane, methanol, and isopropyl alcohol. Milling media was added and the slurry milled to obtain a homogeneous dispersion (e.g. 160 rpm for 24 h). A plasticizer and a binder were added to the suspension and the suspension was further milled (e.g. 60 rpm for 24 h). But the rate can be adjusted depending on the jar size and roller machine used. Solid, dispersant, plasticizer, and binder volume contents in the final composition were 26.23%, 2.68%, 2.64% and 6.10%, respectively. The milling media to solid ratio was kept in the range of 2:1 to 10:1, and preferably 4:1 to 8:1. The produced slurry was tape cast with a blade height of 30 µm to 1000 µm depending on the final thickness required. A slurry was cast on a carrier film. The tape on the carrier film was removed, blanked, and punched into different sizes and shapes such as round, rectangular and square. The milled slurry was tape cast to form platelets having thicknesses from 20-500µm. Binder burn-out was carried out in different atmospheres (air, N₂, H₂, N₂/H₂ or vacuum) in a furnace at a temperature between 300-1100°C. After binder burn-out, the ceramic platelets were sintered in a furnace in a non-oxidizing atmosphere. The sintering profile was adjusted to take into account the starting powder characteristics and furnace conditions. In particular, temperatures were increased at a rate from 2°C/min to 20°C/min and the platelets sintered at a temperature from 1400°C to 1600°C depending on the powder batch, sample size and thickness, and the type of furnace used. The thickness of the sintered ceramic converters ranged from about 50 to 200 µm. Pinhole efficiencies were measured and color points calculated.

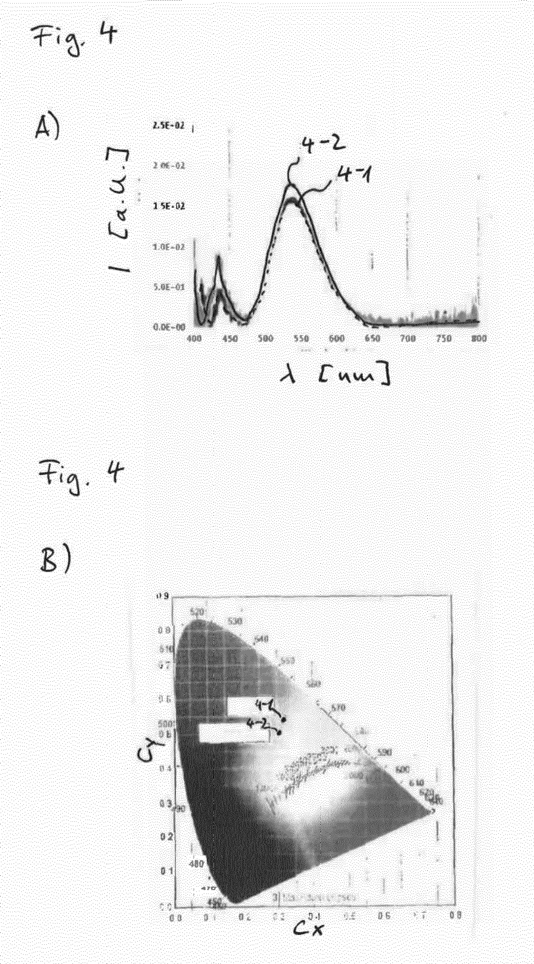

Figure 4A compares the emission spectra of samples exhibiting the highest pinhole efficiencies made by SPS (Example 1, indicated as 4-1) and pressureless sintering (Example 2, indicated as 4-2) methods. It is shown the emission intensity I in arbitrary units (a.U.) as a function of the wavelength λ in nm. The optical parameters of the samples are compared in the Tables below. The data were obtained by using a 443.5nm blue excitation light source. Figure 4B shows the color points of Examples 1 and 2, respectively.

**Table - Optical Parameters of SPS and Pressureless Sintering Samples**

| Sintering method | lumens | color coordinates | | Dominant wavelength (nm) |
|---|---|---|---|---|
| | | x | y | |
| SPS | 6.94 | 0.3419 | 0.6119 | 555.8 |
| Pressureless | 7.69 | 0.3390 | 0.6110 | 555.3 |

and/or

**Table - Optical Parameters of SPS and Pressureless Sintering Samples**

| Sintering method | lumens | color coordinates | | Dominant wavelength (nm) |
|---|---|---|---|---|
| | | x | y | |
| SPS | 6.94 | 0.3202 | 0.5406 | 551.3 |
| Pressureless | 7.69 | 0.3069 | 0.503 | 546.1 |

In the Example 2 sample, if it is assumed that the triclinic (020) peak is the 100%, the ratio of the hexagonal to the triclinic phase is 41% to 59% (in wt.%). The ratio can be changed by changing debinding and sintering temperatures and atmosphere etc.

Hot pressing, hot isostatic pressing and over pressure sintering are three possible alternative methods for sintering the green composite ceramic converters. These are relatively less cost effective and efficient process compared to the process of tape casting followed by pressureless sintering.

In robustness tests in which the composite oxynitride ceramic converters were paired with LEDs, it was found that after 1000 hours of operation the composite ceramic converters were exhibiting nearly fully stable light output. A small color shift towards green was observed, but this seemed to saturate and more importantly the intensity was stable demonstrating the potential for green LED applications. Test conditions: T = 125 °C, I = 1000 mA, Duration = 1000h, and T = 85 °C, rel. humidity = 85 %, I = 500 mA, Duration = 1000h.The pc-LED comprises a reflective housing.

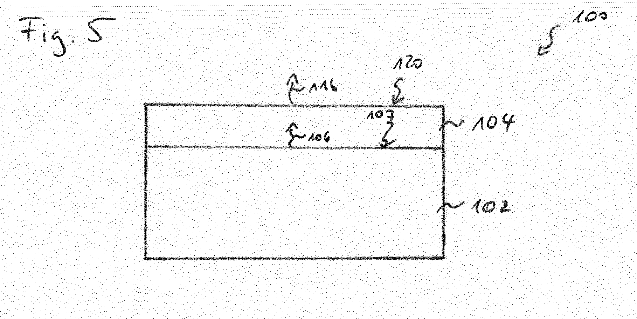

Figure 5 illustrates the use of a composite oxynitride ceramic converter in a phosphor-converted LED (pc-LED) configuration. In particular, a light source 100 in the form of a pc-LED having a composite oxynitride ceramic converter 104 is shown. The composite oxynitride ceramic converter is comprised of a triclinic SrSi₂O₂N₂:Eu²⁺ phase and a hexagonal Sr₃Si₆N₄O₉:Eu²⁺ phase. The ceramic converter 104 generally has a thickness of between 20µm and 500µm and preferably between 100µm and 250µm. In a preferred embodiment, the ceramic converter has the shape of a flat plate, although it is not limited to such.

Primary light 106 emitted from light-emitting surface 107 of the blue-emitting LED die 102 passes into ceramic converter 104 which converts at least a portion of the blue light into a secondary light 116 having a different peak wavelength, e.g., a green light. Preferably, the blue primary light 106 has a peak wavelength in the range of 420nm to 490nm. The color of the light eventually emitted from the light-emitting surface 120 of ceramic converter 104 will depend on the ratio of the amount of unconverted primary light 106 that passes through the ceramic converter to the amount of primary light that is converted to secondary light 116 within the ceramic converter. In some applications, substantially all of the primary light 106 is converted and only converted light 116 is emitted (full conversion).

Pursuant to at least one embodiment, the component comprises a semiconductor chip 102. Said semiconductor chip is set up for generating electromagnetic primary radiation at least from the blue spectral range. The ceramic converter 104 can be arranged in a spatially separated manner from the semiconductor chip 102. For example, the interval between ceramic converter 104 and semiconductor chip 102 can be greater than or equal to 200 µm, preferably greater than or equal to 750 µm, more preferably greater than or equal to 900 µm (so-called remote phosphor conversion). Alternatively, the ceramic converter 104 can directly arranged on the semiconductor chip 102. The semiconductor chip can comprises a semiconductor layer sequence. Said semiconductor layer sequence of the semiconductor chip is preferably based on a III-IV compound semiconductor material. The semiconductor material is preferably a nitride compound semiconductor material such as AlₙIn₁₋ₙ₋ₘGaₘN. However, for the sake of simplicity, only the essential components of the crystal lattice of the semiconductor layer sequence, i.e. Al, As, Ga, In, N or P are stated, even though the latter can be replaced and/or supplemented by small quantities of further substances.

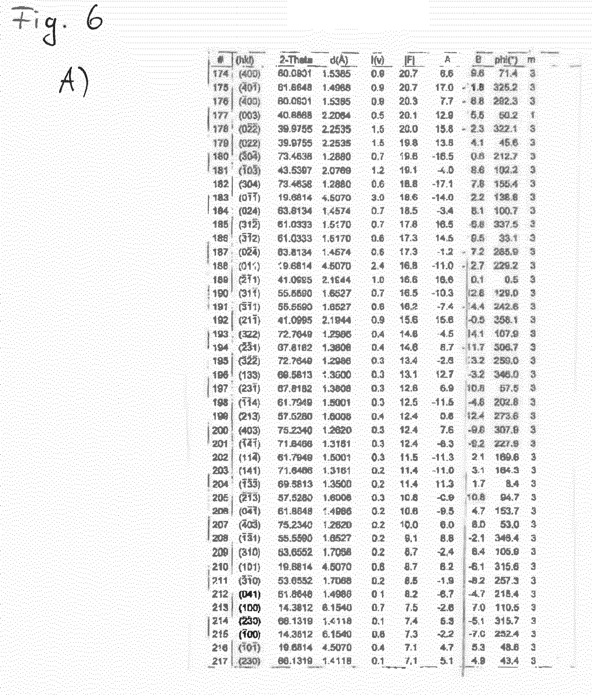

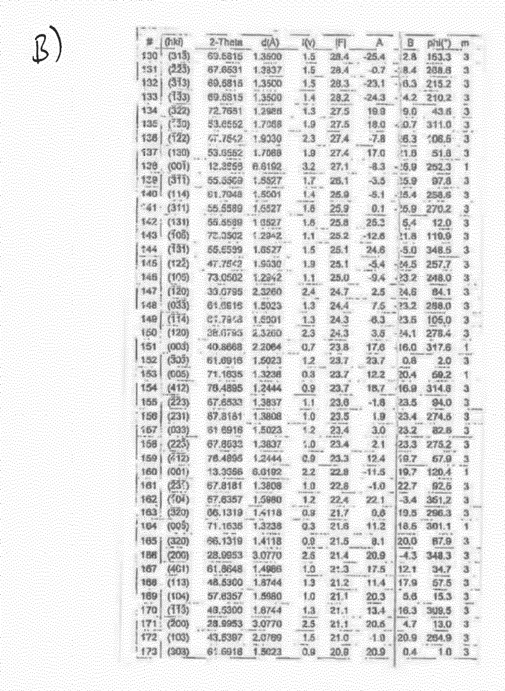

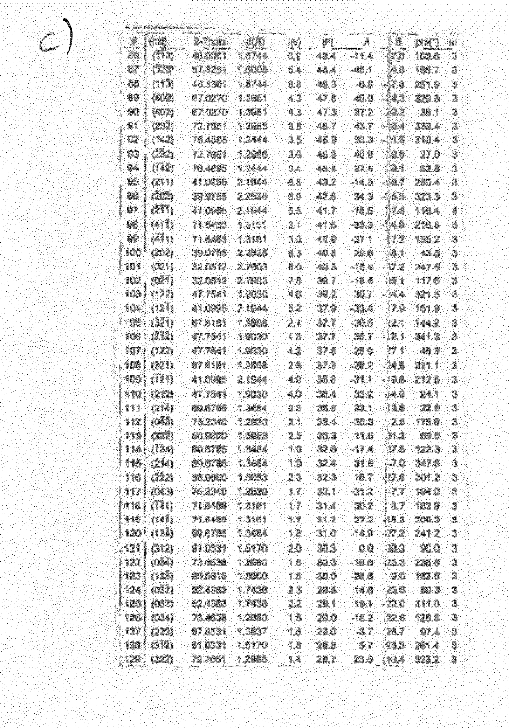

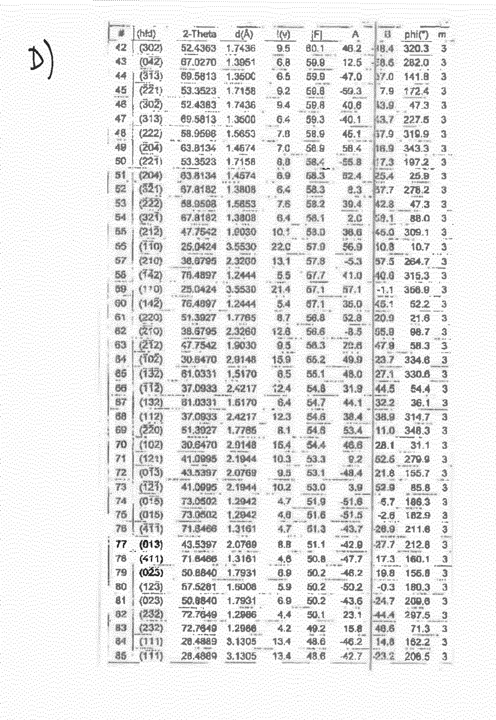

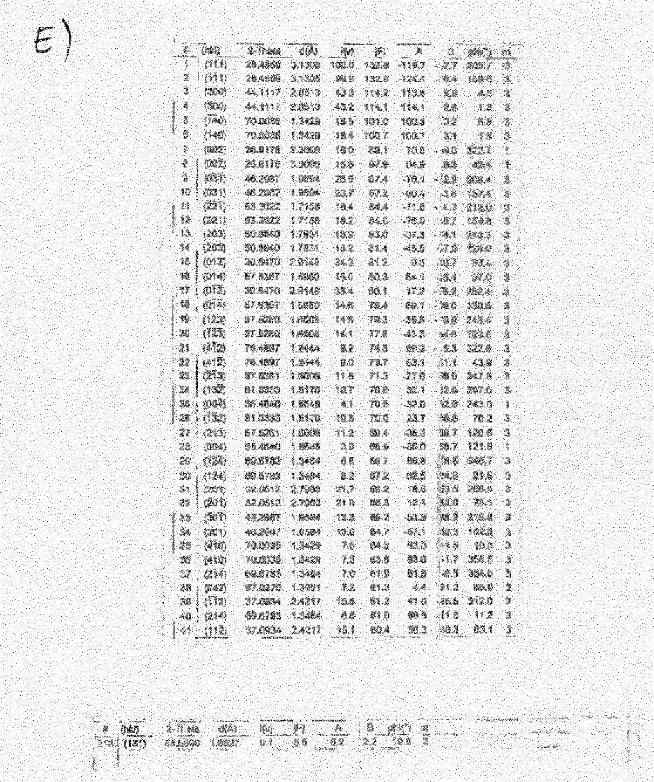

Figures 6A to 6E show x-ray diffraction data, which are calculated. The choosen parameters are: Sr₃Si₆N₄O₉:Eu, Cell: 7.106 x 7.106 x 6.6192 < 90.0 < 90.0 x 120.0 > Vol=2895, Z=1, Dx=3.6219, I/Ic=2.0(v); 218 Reflections in 0.0-76.58 degs >=0.0% (M = multiplicity); hexangonal: P3 (143) [M3], hP22, [Diffractometer LP] [U(I,j)] [F'+F"][A=0.5][VS].

This patent application claims the priority of US patent application 62/172,552.

## Claims

1. A composite oxynitride ceramic converter having a first phase of a triclinic SrSi₂O₂N₂:Eu phosphor and a second phase of a hexagonal Sr₃Si₆N₄O₉:Eu phosphor.

2. The composite oxynitride ceramic converter of claim 1 wherein the SrSi₂O₂N₂:Eu phosphor and the Sr₃Si₆S₄O₉:Eu phosphor contain from 0.1 mole percent Eu to 5 mole percent Eu.

3. The composite oxynitride ceramic converter of claim 1 wherein the SrSi₂O₂N₂:Eu phosphor and the Sr₃Si₆S₄O₉:Eu phosphor contain from 0.1 mole percent Eu to 3 mole percent Eu.

4. The composite oxynitride ceramic converter of claim 1 wherein the SrSi₂O₂N₂:Eu phosphor and the Sr₃Si₆N₄O₉:Eu phosphor contain from 0.3 mole percent Eu to 1.5 mole percent Eu.

5. The composite oxynitride ceramic converter of claim 1 wherein the converter has a relative molar proportion of x moles of the SrSi₂O₂N₂:Eu phosphor to (1-x) moles of the Sr₃Si₆N₄O₉:Eu phosphor where x is from 0.01 to 0.99.

6. The composite oxynitride ceramic converter of claim 1 wherein the converter has a relative molar proportion of x moles of the SrSi₂O₂N₂:Eu phosphor to (1-x) moles of the Sr₃Si₆N₄O₉:Eu phosphor where x is from 0.20 to 0.80.

7. The composite oxynitride ceramic converter of claim 1 wherein the converter has a relative molar proportion of x moles of the SrSi₂O₂N₂:Eu phosphor to (1-x) moles of the Sr₃Si₆N₄O₉:Eu phosphor where x is from 0.30 to 0.60.

8. The composite oxynitride ceramic converter of claim 1 wherein the average grain size in the composite oxynitride ceramic converter is 0.1 to 10 µm.

9. The composite oxynitride ceramic converter of claim 1 wherein the average grain size in the composite oxynitride ceramic converter is 2 to 10 µm.

10. The composite oxynitride ceramic converter of claim 1 wherein the converter emits a green light having a peak wavelength from 540 to 570nm.

11. The composite oxynitride ceramic converter of claim 1 wherein the converter emits a green light having a peak wavelength from 550 to 560nm.

12. The composite oxynitride ceramic converter of claim 1 wherein the converter comprises first grains having a plate-like shape and second grains having an elongated shape with a hexagonal cross section.

13. The composite oxynitride ceramic converter of claim 12 wherein the second grains having the elongated shape have an aspect ratio in a range of greater than 1 to less than about 12.

14. A light source comprising a light emitting diode (LED) and a composite oxynitride ceramic converter, the composite oxynitride ceramic converter having a first phase of a triclinic SrSi₂O₂N₂:Eu phosphor and a second phase of a hexagonal Sr₃Si₆N₄O₉:Eu phosphor.

15. The light source of claim 14 wherein the SrSi₂O₂N₂:Eu phosphor and the Sr₃Si₆N₄O₉:Eu phosphor contain from 0.1 mole percent Eu to 5 mole percent Eu.

16. The light source of claim 14 wherein the converter has a relative molar proportion of x moles of the SrSi₂O₂N₂:Eu phosphor to (1-x) moles of the Sr₃Si₆N₄O₉:Eu phosphor where x is from 0.20 to 0.80.

17. The light source of claim 14 wherein composite oxynitride ceramic converter emits a green light having a peak wavelength from 540 to 570nm.

18. The light source of claim 17 wherein the LED emits a primary light and the composite oxynitride ceramic converter converts substantially all of the primary light to the green light.

19. The light source of claim 18 wherein the primary light has a peak wavelength in the range of 420 to 490nm.

20. The light source of claim 19 wherein the green light has a peak wavelength from 550 to 560nm.

## Patentansprüche

1. Verbund-Oxynitrid-Keramikkonverter mit einer ersten Phase eines triklinischen SrSi₂O₂N₂:Eu-Phosphors und einer zweiten Phase eines hexagonalen Sr₃Si₆N₄O₉:Eu-Phosphors.

2. Verbund-Oxynitrid-Keramikkonverter nach Anspruch 1, wobei der SrSi₂O₂N₂:Eu-Phosphor und der Sr₃Si₆N₄O₉:Eu-Phosphor 0,1 Mol-% Eu bis 5 Mol-% Eu enthalten.

3. Verbund-Oxynitrid-Keramikkonverter nach Anspruch 1, wobei der SrSi₂O₂N₂:Eu-Phosphor und der Sr₃Si₆N₄O₉:Eu-Phosphor 0,1 Mol-% Eu bis 3 Mol-% Eu enthalten.

4. Verbund-Oxynitrid-Keramikkonverter nach Anspruch 1, wobei der SrSi₂O₂N₂:Eu-Phosphor und der Sr₃Si₆N₄O₉:Eu-Phosphor 0,3 Mol-% Eu bis 1,5 Mol-% Eu enthalten.

5. Verbund-Oxynitrid-Keramikkonverter nach Anspruch 1, wobei der Konverter einen relativen molaren Anteil von x Mol des SrSi₂O₂N₂:Eu-Phosphors zu (1-x) Mol des Sr₃Si₆N₄O₉:Eu-Phosphors aufweist, wobei x zwischen 0,01 und 0,99 beträgt.

6. Verbund-Oxynitrid-Keramikkonverter nach Anspruch 1, wobei der Konverter einen relativen molaren Anteil von x Mol des SrSi₂O₂N₂:Eu-Phosphors zu (1-x) Mol des Sr₃Si₆N₄O₉:Eu-Phosphors aufweist, wobei x zwischen 0,20 und 0,80 beträgt.

7. Verbund-Oxynitrid-Keramikkonverter nach Anspruch 1, wobei der Konverter einen relativen molaren Anteil von x Mol des SrSi₂O₂N₂:Eu-Phosphors zu (1-x) Mol des Sr₃Si₆N₄O₉:Eu-Phosphors aufweist, wobei x von 0,30 bis 0,60 beträgt.

8. Verbund-Oxynitrid-Keramikkonverter nach Anspruch 1, wobei die durchschnittliche Korngröße im Verbund-Oxynitrid-Keramikkonverter zwischen 0,1 und 10 µm beträgt.

9. Verbund-Oxynitrid-Keramikkonverter nach Anspruch 1, wobei die durchschnittliche Korngröße in dem Verbund-Oxynitrid-Keramikkonverter zwischen 2 und 10 µm beträgt.

10. Verbund-Oxynitrid-Keramikkonverter nach Anspruch 1, wobei der Konverter ein grünes Licht mit einer Peak-Wellenlänge zwischen 540 und 570 nm emittiert.

11. Verbund-Oxynitrid-Keramikkonverter nach Anspruch 1, wobei der Konverter ein grünes Licht mit einer Peak-Wellenlänge zwischen 550 und 560 nm emittiert.

12. Verbund-Oxynitrid-Keramikkonverter nach Anspruch 1, wobei der Konverter erste Körner mit einer plattenförmigen Form und zweite Körner mit einer länglichen Form mit einem hexagonalen Querschnitt umfasst.

13. Verbund-Oxynitrid-Keramikkonverter nach Anspruch 12, wobei die zweiten Körner mit der länglichen Form ein Aspektverhältnis in einem Bereich von zumindest 1 und höchstens etwa 12 aufweisen.

14. Lichtquelle, umfassend eine lichtemittierende Diode (LED) und einen Verbund-Oxynitrid-Keramikkonverter, wobei der Verbund-Oxynitrid-Keramikkonverter eine erste Phase eines triklinischen SrSi₂O₂N₂:Eu-Phosphors und eine zweite Phase eines hexagonalen Sr₃Si₆N₄O₉:Eu-Phosphors aufweist.

15. Lichtquelle nach Anspruch 14, wobei der SrSi₂O₂N₂:Eu-Phosphor und der Sr₃Si₆N₄O₉:Eu-Phosphor zwischen 0,1 Mol-% Eu und 5 Mol-% Eu enthalten.

16. Lichtquelle nach Anspruch 14, wobei der Konverter einen relativen molaren Anteil von x Mol des SrSi₂O₂N₂:Eu-Phosphors zu (1-x) Mol des Sr₃Si₆N₄O₉:Eu-Phosphors aufweist, wobei x zwischen 0,20 und 0,80 beträgt.

17. Lichtquelle nach Anspruch 14, wobei der Verbund-Oxynitrid-Keramikkonverter ein grünes Licht mit einer Peak-Wellenlänge zwischen 540 und 570 nm emittiert.

18. Lichtquelle nach Anspruch 17, wobei die LED ein primäres Licht emittiert und der Verbund-Oxynitrid-Keramikkonverter im Wesentlichen das gesamte primäre Licht in das grüne Licht umwandelt.

19. Lichtquelle nach Anspruch 18, wobei das primäre Licht eine Peak-Wellenlänge im Bereich zwischen 420 und 490 nm aufweist.

20. Lichtquelle nach Anspruch 19, wobei das grüne Licht eine Peak-Wellenlänge zwischen 550 und 560 nm aufweist.

## Revendications

1. Convertisseur composite en céramique d'oxynitrure présentant une première phase d'une substance fluorescente triclinique SrSi₂O₂N₂:Eu et une seconde phase d'une substance fluorescente hexagonale Sr₃Si₆N₄O₉:Eu.

2. Convertisseur composite en céramique d'oxynitrure selon la revendication 1, dans lequel la substance fluorescente SrSi₂O₂N₂:Eu et la substance fluorescente Sr₃Si₆N₄O₉:Eu contiennent de 0,1 % mol d'Eu à 5 % mol d'Eu.

3. Convertisseur composite en céramique d'oxynitrure selon la revendication 1, dans lequel la substance fluorescente SrSi₂O₂N₂:Eu et la substance fluorescente Sr₃Si₆N₄O₉:Eu contiennent de 0,1 % mol d'Eu à 3 % mol d'Eu.

4. Convertisseur composite en céramique d'oxynitrure selon la revendication 1, dans lequel la substance fluorescente SrSi₂O₂N₂:Eu et la substance fluorescente Sr₃Si₆N₄O₉:Eu contiennent de 0,3 % mol d'Eu à 1,5 % mol d'Eu.

5. Convertisseur composite en céramique d'oxynitrure selon la revendication 1, dans lequel le convertisseur a un pourcentage molaire de x mol de la substance fluorescente SrSi₂O₂N₂:Eu par rapport à (1-x) mol de la substance fluorescente Sr₃Si₆N₄O₉:Eu, où x est compris entre 0,01 et 0, 99.

6. Convertisseur composite en céramique d'oxynitrure selon la revendication 1, dans lequel le convertisseur a un pourcentage molaire de x mol de la substance fluorescente SrSi₂O₂N₂:Eu par rapport à (1-x) mol de la substance fluorescente Sr₃Si₆N₄O₉:Eu, où x est compris entre 0,20 et 0,80.

7. Convertisseur composite en céramique d'oxynitrure selon la revendication 1, dans lequel le convertisseur a un pourcentage molaire de x mol de la substance fluorescente SrSi₂O₂N₂:Eu par rapport à (1-x) mol de la substance fluorescente Sr₃Si₆N₄O₉:Eu, où x est compris entre 0,30 et 0, 60.

8. Convertisseur composite en céramique d'oxynitrure selon la revendication 1, dans lequel la taille moyenne des particules dans le convertisseur composite en céramique d'oxynitrure est comprise entre 0,1 et 10 µm.

9. Convertisseur composite en céramique d'oxynitrure selon la revendication 1, dans lequel la taille moyenne des particules dans le convertisseur composite en céramique d'oxynitrure est comprise entre 2 et 10 µm.

10. Convertisseur composite en céramique d'oxynitrure selon la revendication 1, dans lequel le convertisseur émet une lumière verte présentant une longueur d'onde maximale comprise entre 540 et 570 nm.

11. Convertisseur composite en céramique d'oxynitrure selon la revendication 1, dans lequel le convertisseur émet une lumière verte présentant une longueur d'onde maximale comprise entre 550 et 560 nm.

12. Convertisseur composite en céramique d'oxynitrure selon la revendication 1, dans lequel le convertisseur comprend des premières particules en forme de plateau et des deuxièmes particules de forme allongée à section transversale hexagonale.

13. Convertisseur composite en céramique d'oxynitrure selon la revendication 12, dans lequel les deuxièmes particules de forme allongée ont un rapport largeur/hauteur allant de plus de 1 à moins de 12.

14. Source de lumière comprenant une diode électroluminescente (DEL) et un convertisseur composite en céramique d'oxynitrure, le convertisseur composite en céramique d'oxynitrure présentant une première phase d'une substance fluorescente triclinique SrSi₂O₂N₂:Eu et une seconde phase d'une substance fluorescente hexagonale Sr₃Si₆N₄O₉:Eu.

15. Source de lumière selon la revendication 14, dans laquelle la substance fluorescente SrSi₂O₂N₂:Eu et la substance fluorescente Sr₃Si₆N₄O₉:Eu contiennent de 0,1 % mol d'Eu à 5 % mol d'Eu.

16. Source de lumière selon la revendication 14, dans laquelle le convertisseur a un pourcentage molaire de x mol de la substance fluorescente SrSi₂O₂N₂:Eu par rapport à (1-x) mol de la substance fluorescente Sr₃Si₆N₄O₉:Eu, où x est compris entre 0,20 et 0,80.

17. Source de lumière selon la revendication 14, dans laquelle le convertisseur composite en céramique d'oxynitrure émet une lumière verte présentant une longueur d'onde maximale comprise entre 540 et 570 nm.

18. Source de lumière selon la revendication 17, dans laquelle la DEL émet une lumière primaire et le convertisseur composite en céramique d'oxynitrure convertit substantiellement la totalité de la lumière primaire en lumière verte.

19. Source de lumière selon la revendication 18, dans laquelle la lumière primaire présente une longueur d'onde maximale comprise entre 420 et 490 nm.

20. Source de lumière selon la revendication 19, dans laquelle la lumière verte présente une longueur d'onde maximale comprise entre 550 et 560 nm.
